(19) Europäisches Patentamt
European Patent Office
Office européen des brevets

(11) EP 2 557 099 B1

(12) EUROPEAN PATENT SPECIFICATION

(45) Date of publication and mention of the grant of the patent:
**12.02.2020 Bulletin 2020/07**

(21) Application number: **11814446.8**

(22) Date of filing: **19.07.2011**

(51) Int Cl.:
***C08G 8/28*** (2006.01) ***C08G 59/62*** (2006.01)
***H05K 1/03*** (2006.01)

(86) International application number:
**PCT/JP2011/066327**

(87) International publication number:
**WO 2012/017816 (09.02.2012 Gazette 2012/06)**

(54) **NOVEL PHENOL RESIN, CURABLE RESIN COMPOSITION, CURED ARTICLE THEREOF, AND PRINTED WIRING BOARD**

NEUARTIGES PHENOLHARZ, HÄRTBARE HARZZUSAMMENSETZUNG, GEHÄRTETER ARTIKEL DARAUS UND BESTÜCKTE LEITERPLATTE

NOUVELLE RÉSINE PHÉNOLIQUE, COMPOSITION DE RÉSINE DURCISSABLE, ARTICLE DURCI CONSTITUÉ DE LADITE RÉSINE ET CARTE POUR CIRCUITS IMPRIMÉS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.08.2010 JP 2010177351**

(43) Date of publication of application:
**13.02.2013 Bulletin 2013/07**

(73) Proprietor: **DIC Corporation**
**Tokyo 174-8520 (JP)**

(72) Inventor: **SATOU Yutaka**
**Ichihara-shi**
**Chiba 290-8585 (JP)**

(74) Representative: **Adam, Holger et al**
**Kraus & Weisert**
**Patentanwälte PartGmbB**
**Thomas-Wimmer-Ring 15**
**80539 München (DE)**

(56) References cited:
**EP-A2- 0 136 110**
**EP-A2- 0 512 519**
**JP-A- 2000 178 329**
**JP-A- 2001 011 102**
**JP-A- 2004 197 020**
**JP-A- 2004 197 020**
**JP-A- 2004 277 624**
**JP-A- 2004 277 624**
**JP-A- 2009 155 638**
**JP-A- 2009 155 638**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 557 099 B1

## Description

### Technical Field

The present invention relates to a novel phenol resin which produces a cured product having excellent heat resistance and low thermal expansibility and which can be preferably used for a printed circuit board, a semiconductor encapsulant, a coating material, cast molding, etc., a curable resin composition containing the phenol resin and a cured product thereof, and a printed circuit board having excellent heat resistance and low thermal expansibility.

### Background Art

Phenol resins are used for an adhesive, a molding material, a coating material, a photoresist material, a color developing material, an epoxy resin raw material, a curing agent for epoxy resins, etc., and in view of the excellent heat resistance and moisture resistance of resultant cured products, phenol resins are widely used for a curable resin composition containing a phenol resin as a main agent or a curable resin composition containing an epoxidized resin and a phenol resin as a curing agent for an epoxy resin in the electric and electronic field such as a semiconductor encapsulant, an insulating material for a printed circuit board, etc.

Among these various applications, in the field of printed circuit boards, the tendency toward higher densities due to narrowing of the wiring pitches of semiconductor devices becomes remarked with miniaturization and improvement in performance of electronic apparatuses. As a corresponding semiconductor mounting method, a flip-chip bonding method of bonding a semiconductor device and a substrate with solder balls is widely used. The flip-chip bonding method is a so-called reflow-system semiconductor mounting method in which solder balls are disposed between a circuit board and a semiconductor and the whole is heated to cause fused-junction between the circuit board and the semiconductor. Therefore, the circuit board is exposed to a high-heat environment during solder reflowing, and thus large stress occurs in the solder balls, which are used for bonding together the circuit board and the semiconductor, due to thermal contraction of the circuit board, thereby causing faulty connection in wiring. Therefore, a low-thermal-expansion material is required as an insulating material used for printed circuit boards.

In addition, high-melting-point solder not using lead has become a main stream by the legal regulations for environmental problems. The lead-free solder is used at a temperature about 20 to 40°C higher than that for usual eutectic solder, and thus a curable resin composition is required to have higher heat resistance.

In this way, a curable resin composition used for insulating materials for printed circuit boards is required to have a high degree of heat resistance and low thermal expansibility, and a phenol resin material capable of complying with these requirements is much expected.

In order to comply with these requirements, for example, a naphthol resin produced by reaction between naphthol and formaldehyde (refer to Patent Literature 1 below) is proposed as a material capable of resolving the technical problems of heat resistance etc. The naphthol resin has a skeleton with higher rigidity than general phenol novolac resins, and thus the effect of improving heat resistance is recognized in the resultant cured product, but heat resistance does not reach the present required level. Also, a low coefficient of thermal expansion of the cured product is not satisfactory.

### Citation List

### Patent Literature

PTL 1: Japanese Unexamined Patent Application Publication No. 2007-31527

JP 2009 155638 A discloses a modified dimethylnaphthalene formaldehyde resin high in heat resistance and useful as thermosetting resin.

JP 2004 277624 A discloses a method for preparing a naphthol resin, a naphthol compound and aldehydes and/or hexamethylenetetramine that are brought into reaction with each other in a system that contains virtually no organic solvent.

JP 2004 197020 A discloses a phenolic resin composition having high carbonization rate in baking and carbonization that is composed of a phenolic resin and an aromatic polycyclic quinone compound.

EP 0 512 519 A discloses the copolycondensation of a phenol, a naphthol and formaldehyde that proceeds smoothly in the presence of an acid and a metallic element selected from the group consisting of transition metallic elements and metallic elements of Group IIa, Group IIIa, Group IVa, Group Va and Group VIa of the Periodic Table, and a naphthol-modified phenolic resin which has a large molecular weight and does not gel is obtained.

EP 0 136 110 relates to a positive photosensitive composition, useful as a photoresist, comprising a 1,2-naphthoquinone diazide compound and a novolak binder resin containing as condensation components β-naphthol, or

α-naphthol and p-cresol.

## Summary of Invention

### Technical Problem

Accordingly, a problem to be solved by the present invention is to provide a phenol resin according to the claims which produces a cured product having excellent heat resistance and a low coefficient of thermal expansion, a curable resin composition containing the phenol resin as a curing agent for an epoxy resin, a cured product of the curable resin composition, and a printed circuit board having excellent heat resistance and low thermal expansibility.

### Solution to Problem

As a result of intensive research for resolving the problem, the inventors have found that when a naphthol resin produced by reaction between a naphthol compound and formaldehyde is oxidized to form a quinone portion in its resin structure, the heat resistance of a cured product is significantly improved, and thermal expansibility is lowered, leading to the achievement of the present invention.

The present invention relates to a novel phenol resin characterized by having a resin structure in which a naphthol skeleton (n) and a naphthoquinone skeleton (q) are bonded through a methylene bond, wherein a polycondensate (a) of a naphthol compound and formaldehyde is oxidized to form the naphthoquinone skeleton (q) in a resin structure of the polycondensate, and wherein the naphthoquinone skeleton (q) is represented by structural formula q1 or q2 below:

[Chem. 1]

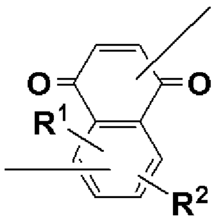

q1

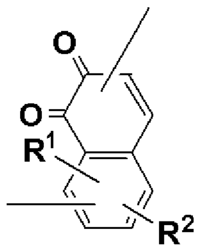

q2

wherein $R^1$ and $R^2$ are each independently a hydrogen atom, a methyl group, an ethyl group, or a methoxy group, and two lines in the structural formula q1 or q2 each indicate a bond to another structural site and may be positioned on the same ring or different rings of the two rings constituting the structure.

Further, the present invention relates to a curable resin composition containing, as essential components, a curing agent (A) for an epoxy resin and an epoxy resin (B), wherein the curing agent (A) for an epoxy resin includes the novel phenol resin.

Further, the present invention relates to a cured product produced by a curing reaction of the curable resin composition.

Further, the present invention relates to a printed circuit board produced by impregnation of a reinforcement substrate with a resin composition varnish and then lamination, the resin composition varnish being prepared by mixing a curable resin composition with an organic solvent (C) .

Further embodiments are disclosed in the claims.

### Advantageous Effects of Invention

According to the present invention, it is possible to provide a novel phenol resin which produces a cured product having excellent heat resistance and a low coefficient of thermal expansion, a curable resin composition containing the phenol resin as a curing agent for an epoxy resin, a cured product of the curable resin composition, and a printed circuit board having excellent heat resistance and low thermal expansibility.

### Brief Description of Drawings

[Fig. 1] Fig. 1 is a GPC chart of quinone skeleton-containing phenol resin (A-2) produced in Example 1.
[Fig. 2] Fig. 2 is a GPC chart of quinone skeleton-containing phenol resin (A-4) produced in Example 2.
[Fig. 3] Fig. 3 is a $^{13}C$-NMR chart of quinone skeleton-containing phenol resin (A-4) produced in Example 2.
[Fig. 4] Fig. 4 shows a MS spectrum of quinone skeleton-containing phenol resin (A-4) produced in Example 2.
[Fig. 5] Fig. 5 is a FT-IR chart of quinone skeleton-containing phenol resin (A-4) produced in Example 2.
[Fig. 6] Fig. 6 is a GPC chart of quinone skeleton-containing phenol resin (A-5) produced in Example 3.
[Fig. 7] Fig. 7 is a GPC chart of quinone skeleton-containing phenol resin (A-6) produced in Example 4.
[Fig. 8] Fig. 8 is a GPC chart of quinone skeleton-containing phenol resin (A-7) produced in Example 5.

Description of Embodiments

The present invention is described in detail below.

A novel phenol resin of the present invention is characterized by having a resin structure in which a naphthol skeleton (n) and a naphthoquinone skeleton (q) are bonded through a methylene bond, wherein a polycondensate (a) of a naphthol compound and formaldehyde is oxidized to form the naphthoquinone skeleton (q) in a resin structure of the polycondensate, and wherein the naphthoquinone skeleton (q) is represented by structural formula q1 or q2 below:

[Chem. 1]

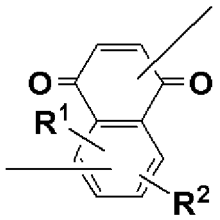
q1

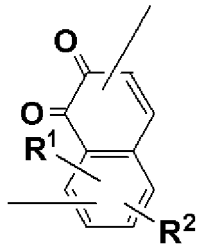
q2

wherein $R^1$ and $R^2$ are each independently a hydrogen atom, a methyl group, an ethyl group, or a methoxy group, and two lines in the structural formula q1 or q2 each indicate a bond to another structural site and may be positioned on the same ring or different rings of the two rings constituting the structure. That is, when the novel phenol resin of the present invention is used as a curing agent for an epoxy resin, curability is significantly improved because the resin structure has the naphthoquinone skeleton (q), thereby improving heat resistance and decreasing thermal expansibility as compared with a so-called naphthol novolac resin.

Examples of a compound having the naphthol skeleton (n) include α-naphthol, β-naphthol, and various naphthol compounds having a structure in which a naphthol nucleus is substituted with an alkyl group such as a methyl group, an ethyl group, a methoxy group, or the like.

The naphthoquinone skeleton (q) include those represented by structural formula q1 or q2 below.

[Chem. 1]

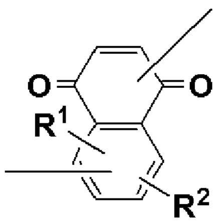
q1

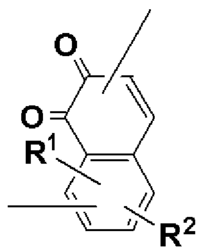
q2

In the structural formula q1 or q2, $R^1$ and $R^2$ are each independently a hydrogen atom, a methyl group, an ethyl group, or a methoxy group. In particular, from the viewpoint of low thermal expansibility and excellent heat resistance, both $R^1$ and $R^2$ are preferably hydrogen atoms. In the present invention, in particular, from the viewpoint of low thermal expansibility and excellent heat resistance of a cured product, the structural formula q1 is preferred. In the structural formula q1 or q2, two lines each indicate a bond to another structural site and may be positioned at the same ring or different rings of the two rings constituting the structure.

The novel phenol resin of the present invention has the structure in which the naphthol skeleton (n) and the naphthoquinone skeleton (q) are bonded through the methylene bond, wherein a polycondensate (a) of a naphthol

compound and formaldehyde is oxidized to form the naphthoquinone skeleton (q) in a resin structure of the polycondensate, and wherein the naphthoquinone skeleton (q) is represented by structural formula q1 or q2 below:

[Chem. 1]

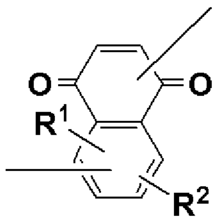

q1

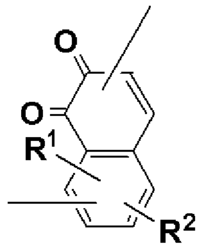

q2

wherein $R^1$ and $R^2$ are each independently a hydrogen atom, a methyl group, an ethyl group, or a methoxy group, and two lines in the structural formula q1 or q2 each indicate a bond to another structural site and may be positioned on the same ring or different rings of the two rings constituting the structure. In particular, in view of the excellent heat resistance of a cured product, it is preferred that the aromatic nuclei of the naphthol skeleton (n) or the naphthoquinone skeleton (q) are linked to each other through the methylene bond serving as a bridging group to form a novolac polymer. Such a novolac polymer has a resin structure, specifically, a structure represented by the following structural formula I:

[Chem. 2]

$$X\left[-CH_2-X\right]_n-CH_2-X \qquad \mathrm{I}$$

In the formula, at least one of Xs is the naphthoquinone skeleton (q), and the other Xs are each the naphthol skeleton (n). In addition, n is a repeat unit and an integer of 0 or more.

In the novel phenol resin, the total number of nuclei (in the skeletons, a condensed ring is considered as 1 nucleus) of the naphthol skeleton (n) and the naphthoquinone skeleton (q) of the resin is preferably in a range of 3 to 10 on average in view of the excellent heat resistance of a cured produce, and particularly preferably in a range of 3 to 6 on average in view of the more significant effect of improving heat resistance. When the novel phenol resin is represented by the structural formula I, the total number of nuclei of the naphthol skeleton (n) and the naphthoquinone skeleton (q) is equal to the total number of Xs in the structural formula I and is a value corresponding to n+2.

The average number of nuclei can be calculated according to a calculation expression below using the number-average molecular weight (Mn) of the phenol resin measured under GPC measurement conditions described below. In the expression, "Y" represents a mass number of the naphthol skeleton (n), "Z" represents a mass number of the naphthoquinone skeleton (q), "p" represents a ratio (molar ratio) of the naphthol skeleton (n) present to the naphthoquinone skeleton (q) present, and "q" represents a ratio (molar ratio) of the naphthoquinone skeleton (q) present to the naphthol skeleton (n) present.

$$\text{Average number of nuclei} = (Mn - x)/(x + 12) + 1$$

$$x = p/100 \times Y + q/100 \times Z$$

More specifically, "p" and "q" are each a value derived by a calculation method for a molar ratio [naphthoquinone skeleton (q)/carbon atom to which phenolic hydroxyl group (p) is bonded] according to $^{13}C$-NMR measurement described below.

<GPC: measurement conditions>

Measurement apparatus: "HLC-8220 GPC" manufactured by Tosoh Corporation
Column: Guard Column "HXL-L" manufactured by Tosoh Corporation
+ "TSK-GEL G2000HXL" manufactured by Tosoh Corporation

+ "TSK-GEL G2000HXL" manufactured by Tosoh Corporation
+ "TSK-GEL G3000HXL" manufactured by Tosoh Corporation
+ "TSK-GEL G4000HXL" manufactured by Tosoh Corporation
Detector: RI (differential refractometer)
Data processing: "GPC-8020 model II version 4.10" manufactured by Tosoh Corporation
Measurement conditions:

| | |
|---|---|
| Column temperature | 40°C |
| Developing solvent | tetrahydrofuran |
| Flow rate | 1.0ml/min |

Standard: using monodisperse polystyrene having a known molecular weight according to a measurement manual of the "GPC-8020 model II version 4.10".

(Polystyrene used)

"A-500" manufactured by Tosoh Corporation
"A-1000" manufactured by Tosoh Corporation
"A-2500" manufactured by Tosoh Corporation
"A-5000" manufactured by Tosoh Corporation
"F-1" manufactured by Tosoh Corporation
"F-2" manufactured by Tosoh Corporation
"F-4" manufactured by Tosoh Corporation
"F-10" manufactured by Tosoh Corporation
"F-20" manufactured by Tosoh Corporation
"F-40" manufactured by Tosoh Corporation
"F-80" manufactured by Tosoh Corporation
"F-128" manufactured by Tosoh Corporation
Sample: prepared by filtering, with a microfilter, a tetrahydrofuran solution of 1.0% by mass in terms of resin solid content (50 μl).
3) $^{13}$C-NMR: Measurement conditions are as follows.
Apparatus: AL-400 manufactured by JEOL, Ltd.
Measurement mode: SGNNE (NOE-suppressed 1H complete decoupling method)
Solvent: dimethylsulfoxide
Pulse angle: 45°C pulse
Sample concentration: 30 wt%
Number of acquisitions: 10000

From the viewpoint of easy production, the novel phenol resin preferably has a resin structure in which a naphthol skeleton in a portion of a polycondensate (a) of a naphthol compound and formaldehyde is converted to a naphthoquinone skeleton by oxidizing the polycondensate (a).

Specific examples of the polycondensate (a) of the naphthol compound and formaldehyde include α-naphthol novolac resins; β-naphthol novolac resins; various novolac resins having molecular structures produced by nuclear substitution of these naphthol novolac resins with an alkyl group such as a methyl group, an ethyl group, a methoxy group, or the like; novolac compounds of 1,6-dihydroxynaphthalene; and the like. Among these, α-naphthol novolac resins are preferred from the viewpoint of the excellent effect of improving heat resistance and low thermal expansibility by the formation of a quinone structure.

Examples of the naphthol compound used for producing the polycondensate (a) include α-naphthol, β-naphthol, compounds produced by nuclear substitution of these compounds with an alkyl group such as a methyl group, an ethyl group, a methoxy group, or the like, and the like. In particular, α-naphthol is preferred in view of excellent reactivity.

In addition, in view of further improved heat resistance of a cured product, the polycondensate (a) of the naphthol compound and formaldehyde is preferably produced by polycondensation of the formaldehyde with the naphthol compound used in combination with another phenol compound, a phenol novolac resin, or a cresol novolac resin.

Examples of the other phenol compound used include phenol, cresol, dimethylphenol, and the like. Among these, phenol or cresol is preferred in view of improved reactivity of the novel phenol resin as a final product.

In view of the significant effect of combination with the other phenol compound, the amount of the other phenol compound used is preferably 0.5 to 10% by mass in terms of a ratio in the raw material component. The raw material component represents the total amount of the naphthol compound, formaldehyde, and phenol novolac or alkylphenol novolac.

On the other hand, the phenol novolac resin or cresol novolac resin preferably has a softening point in a range of 60°C to 120°C and an average number of nuclei in a range of 3 to 10 determined by GPC measurement under the above-described conditions from the viewpoint that fluidity of the novel phenol resin as the final product can be improved, and heat resistance of a cured produce can be further enhanced.

In view of the significant effect of combination with the phenol novolac or alkylphenol novolac, the amount of the phenol novolac or alkylphenol novolac used is preferably 0.5 to 10% by mass in terms of a ratio in the raw material component. The raw material component represents the total amount of the naphthol compound, formaldehyde, and phenol novolac or alkylphenol novolac.

On the other hand, examples of a formaldehyde source of the formaldehyde include formalin, paraformaldehyde, trioxane, and the like. As the formalin, 30 to 60% by mass of formalin is preferred from the viewpoint of water reducibility and production workability.

The polycondensate (a) can be produced by reaction between the naphthol compound and the formaldehyde in the presence of an acid catalyst. Examples of the acid catalyst used in the reaction include inorganic acids such as hydrochloric acid, sulfuric acid, phosphoric acid, and the like; organic acids such as methanesulfonic acid, p-toluenesulfonic acid, oxalic acid, and the like; and Lewis acids such as boron trifluoride, anhydrous aluminum chloride, zinc chloride, and the like. The amount of use is preferably in a range of 0.1 to 5% by weight relative to the total weight of the raw materials charged.

In addition, the reaction temperature of the reaction between the naphthol compound and the formaldehyde, and if required, the other phenol compound or the phenol novolac resin or cresol novolac resin is preferably in the range of 80 to 150°C from the viewpoint of excellent reactivity.

The thus-produced polycondensate (a) of the naphthol compound and the formaldehyde preferably has a softening point in a range of 110 to 150°C in view of excellent heat resistance of a cured product.

As described above, the novel phenol resin of the present invention can be produced by oxidizing the polycondensate (a) of the naphthol compound and the formaldehyde to form the naphthoquinone skeleton (q) in the resin structure of the polycondensate.

Next, the ratio of the naphthoquinone skeleton (q) to the naphthol skeleton (n) present in the novel phenol resin of the present invention is such that according to $^{13}C$-NMR measurement, the molar ratio [naphthoquinone skeleton (q)/carbon atom to which phenolic hydroxyl group (p) is bonded] of the naphthoquinone skeleton (q) to phenolic hydroxyl groups (p) present in the novel phenol resin is preferably 0.1/99.9 to 20/80 in view of low thermal expansibility and excellent heat resistance of a cured product. In particular, the ratio is preferably in the range of 0.5/99.5 to 15/85 in view of the more significant effect.

The molar ratio [naphthoquinone skeleton (q)/carbon atom to which phenolic hydroxyl group (p) is bonded] is a value calculated based on $^{13}C$-NMR measurement, specifically calculated based on measurement according to a method described below.

<$^{13}C$-NMR measurement conditions>

$^{13}C$-NMR: Measurement conditions are as follows.
Apparatus: AL-400 manufactured by JEOL, Ltd.
Measurement mode: SGNNE (NOE-suppressed 1H complete decoupling method)
Solvent: dimethylsulfoxide
Pulse angle: 45°C pulse
Sample concentration: 30 wt%
Number of acquisitions: 10000

<Method for calculating molar ratio [naphthoquinone skeleton (q)/carbon atom to which phenolic hydroxyl group (p) is bonded]>

In measurement of the novel phenol resin of the present invention under the above-described $^{13}C$-NMR measurement conditions, a relation between the integrated value ($\alpha$) of a peak of a carbon atom, to which a phenolic hydroxyl group (p) is bonded and which is detected between 145 ppm and 160 ppm, and the integrated value ($\beta$) of a peak of a carbon atom, to which oxygen of the naphthoquinone skeleton (q) is bonded and which is detected between 170 ppm

and 190 ppm, satisfies expression (1) and expression (2) below. Here, (X) represents the number of moles of the phenolic hydroxyl group (p), and (Y) represents the number of moles of the naphthoquinone skeleton (q).

$$X = \alpha \qquad \text{Expression (1)}$$

$$Y = \beta/2 \qquad \text{Expression (2)}$$

Therefore, the molar ratio can be calculated as a value of (Y/X) in expression (3) below from the expression (1) and expression (2) .

$$Y/X = \beta/2\alpha \qquad \text{Expression (3)}$$

Examples of a method for oxidizing the polycondensate (a) of the naphthol compound and formaldehyde include a method of allowing to stand or stirring the polycondensate (a) of the naphthol compound and formaldehyde in the presence of air in a non-closed vessel, and a method of allowing to stand or stirring the polycondensate (a) in a non-closed or closed vessel while blowing air into the vessel. In this case, the temperature condition of oxidation may be equal to or lower than the softening point of the polycondensate (a), and is preferably in the range of, for example, 25°C to 120°C, in view of excellent productivity. In addition, the oxidation time is, for example, 1 to 72 hours, but the molar ratio [naphthoquinone skeleton (q)/carbon atom to which phenolic hydroxyl group (p) is bonded] can be controlled by the oxidation time because the value of molar ratio increases as the oxidation time increases.

The thus-formed novel phenol resin of the present invention preferably has a softening point in the range of 110 to 180 in view of excellent heat resistance of a cured product.

In addition, in FT-IR measurement of the novel phenol resin of the present invention under conditions described below, a quinone absorbance ratio ($\gamma/\omega$) calculated from an absorption value ($\gamma$) of a peak due to a quinone skeleton, which is detected between 1560 $cm^{-1}$ and 1600 $cm^{-1}$, and an absorption value ($\omega$) of a peak due to an aromatic skeleton detected between 1630 $cm^{-1}$ and 1670 $cm^{-1}$, is preferably in the range of 0.1 to 1.0 from the viewpoint of low thermal expansibility and excellent heat resistance of a cured product.

<FT-IR measurement condition>

Apparatus: FT/IR-4200 type A manufactured by JASCO Corporation
Measurement method: KBr tablet method
Measurement mode: absorbance (Abs)
Resolution: 4 $cm^{-1}$
Number of acquisitions: 32
Abscissa: Wavenumber ($cm^{-1}$)
Ordinate: Abs

<Method for calculating peak absorption values ($\gamma$ and $\omega$) >

The peak absorption values ($\gamma$) and ($\omega$) are each calculated from a height from a base line between the minimum absorption value (a) at 1500 $cm^{-1}$ to 1560 $cm^{-1}$ and the minimum absorption value (b) at 1660 $cm^{-1}$ to 1800 $cm^{-1}$.

As described above, the novel phenol resin detailed above is particularly useful as a curing agent for an epoxy resin. Therefore, in view of the excellent effect of improving heat resistance and low thermal expansibility, the phenol resin is preferably used as a curing agent (A) for an epoxy resin in a curable resin composition of the present invention which contains the curing agent (A) for an epoxy resin and an epoxy resin (B) as essential components.

As the epoxy resin (B), various epoxy resins can be used. Examples thereof include bisphenol epoxy resins such as bisphenol A epoxy resins, bisphenol F epoxy resins, and the like; biphenyl epoxy resins such as biphenyl epoxy resins, tetramethylbiphenyl epoxy resins, and the like; novolac epoxy resins such as phenol novolac epoxy resins, cresol novolac epoxy resins, bisphenol A novolac epoxy resins, epoxy compounds of condensates of phenols and phenolic hydroxyl group-containing aromatic aldehyde, biphenyl novolac epoxy resins, and the like; triphenylmethane epoxy resins; tetraphenylethane epoxy resins; dicyclopentadiene-phenol addition reaction-type epoxy resins; phenolaralkyl

epoxy resins; epoxy resins each having a naphthalene skeleton in its molecular structure, such as naphthol novolac epoxy resins, naphtholaralkyl epoxy resins, naphthol-phenol co-condensed novolac epoxy resins, naphthol-cresol co-condensed novolac epoxy resins, diglycidyloxynaphthalene; 1, 1-bis(2, 7-diglycidyloxy-1-naphthyl)alkanes, and the like; and phosphorus atom-containing epoxy resins. These epoxy resins may be used alone or as a mixture of two or more.

Examples of the phosphorus atom-containing epoxy resins include epoxy compounds of 9,10-dihydro-9-oxa-10-phosphaphenanthrene-10-oxide (hereinafter abbreviated as "HCA"), epoxy compounds of phenol resins produced by reaction between HCA and quinones, HCA-modified phenol novolac epoxy resins, HCA-modified cresol novolac epoxy resins, bisphenol A epoxy resins modified with phenol resins produced by reaction between HCA and quinones, and the like.

Among the above-described epoxy resins, the epoxy resins each having a naphthalene skeleton in its molecular structure and the phenol novolac epoxy resins are preferred particularly in view of heat resistance, and the bisphenol epoxy resins and the novolac epoxy resins are preferred in view of solvent solubility.

The mixing ratio between the curing agent (A) for an epoxy resin and the epoxy resin (B) which are detailed above is preferably such that the equivalent ratio (epoxy group/hydroxyl group) of epoxy groups in the epoxy resin (B) to phenolic hydroxyl groups in the phenol resin composition is 1/1.5 to 1/0.7 in view of excellent heat resistance.

The curable resin composition of the present invention uses the phenol resin composition as the curing agent for an epoxy resin, but if required, another curing agent (A') for an epoxy resin may be properly combined. Usable examples of the other curing agent for an epoxy resin include various known curing agents such as an amine-based compound, an amide-based compound, an acid anhydride-based compound, a phenol-based compound, and the like. Specific examples of the amine-based compound include diaminodiphenylmethane, diethylenetriamine, triethylenetetramine, diaminodiphenylsulfone, isophoronediamine, imidazole, $BF_3$-amine complex, guanidine derivatives, and the like. Examples of the amide-based compound include dicyandiamide, a polyamide resin synthesized from linolenic acid dimer and ethylenediamine, and the like. Examples of the acid anhydride-based compound include phthalic anhydride, trimellitic anhydride, pyromellitic anhydride, maleic anhydride, tetrahydrophthalic anhydride, methyltetrahydrophthalic anhydride, methylnadic anhydride, hexahydrophthalic anhydride, methylhexahydrophthalic anhydride, and the like. Examples of the phenol-based compound include polyhydric phenol compounds such as phenol novolac resins, cresol novolac resins, aromatic hydrocarbon formaldehyde resin-modified phenol resins, dicyclopentadienephenol addition-type resins, phenol aralkyl resins (Xylok resin), naphthol aralkyl resins, trimethylolmethane resins, tetraphenylolethane resins, naphthol novolac resins, naphthol-phenol co-condensed novolac resins, naphthol-cresol co-condensed novolac resins, biphenyl-modified phenol resins (polyhydric phenol compounds each having phenol nuclei connected through a bismethylene group), biphenyl-modified naphthol resins (polyhydric naphthol compounds each having phenol nuclei connected through a bismethylene group), aminotriazine-modified phenol resins (polyhydric phenol compounds each having phenol nuclei connected through melamine or benzoguanamine), alkoxy group-containing aromatic ring-modified novolac resins (polyhydric phenol compounds each having phenol nuclei and alkoxy group-containing aromatic rings connected through formaldehyde), and the like.

When the other curing agent (A') for an epoxy resin is used, the amount of use is preferably such that the equivalent ratio (active hydrogen/hydroxyl group) of active hydrogen in the curing agent (A') for an epoxy resin and phenolic hydroxyl group in the curing agent (A) for an epoxy resin is in the range of 1/10 to 5/1.

If required, the curable resin composition of the present invention may be appropriately combined with a curing accelerator. As the curing accelerator, various compounds can be used, and for example, a phosphorus-based compound, a tertiary amine, imidazole, an organic acid metal salt, a Lewis acid, an amine complex salt, and the like can be used. In particular, in application to a semiconductor encapsulant, from the viewpoint of excellent curability, heat resistance, electric characteristics, and moistureproof reliability, 2-ethyl-4-methylimidazole is preferred as the imidazole, triphenylphosphine is preferred as the phosphorus-based compound, and 1,8-diazabicyclo-[5.4.0]-undecene (DBU) is preferred as the tertiary amine.

When the above-detailed curable resin composition of the present invention is prepared as varnish for a printed circuit board, an organic solvent (C) is preferably mixed with above-described components. Examples of the organic solvent which can be used include methyl ethyl ketone, acetone, dimethylformamide, methyl isobutyl ketone, methoxypropanol, cyclohexanone, methyl cellosolve, ethyl diglycol acetate, propylene glycol monomethyl ether acetate, and the like. The organic solvent and the amount of use thereof can be appropriately selected, but, for example, in application to a printed circuit board, a polar solvent having a boiling point of 160°C or less, such as methyl ethyl ketone, acetone, dimethylformamide, or the like, is preferably used at a ratio of 40 to 80% by mass in terms of nonvolatile content. In application to an adhesive film for build-up, examples of the organic solvent which is preferably used include ketones such as acetone, methyl ethyl ketone, cyclohexanone, and the like; acetates such as ethyl acetate, butyl acetate, cellosolve acetate, propylene glycol monomethyl ether acetate, carbitol acetate, and the like; carbitols such as cellosolve, butyl carbitol, and the like; aromatic hydrocarbons such as toluene, xylene, and the like; dimethylformamide; dimethylacetamide; N-methyl pyrrolidone; and the like. Such an organic solvent is preferably used at a ratio of 30 to 60% by mass in terms of nonvolatile content.

In addition, the heat-curable resin composition may further contain a non-halogen flame retardant substantially not containing a halogen atom which is mixed for further enhancing flame retardancy, for example, in the field of printed circuit boards.

Examples of the non-halogen flame retardant include a phosphorus-based flame retardant, a nitrogen-based flame retardant, a silicone-based flame retardant, an inorganic flame retardant, an organic metal salt-based flame retardant, and the like. Use of these flame retardants is not particularly limited, and they may be used alone or in combination of a plurality of flame retardants of the same type or different types.

As the phosphorus-based flame retardant, either an inorganic type or an organic type can be used. Examples of an inorganic compound include red phosphorus; ammonium phosphates such as monoammonium phosphate, diammonium phosphate, triammonium phosphate, ammonium polyphosphate, and the like; and inorganic nitrogen-containing phosphorus compounds such as phosphoric amide, and the like.

The red phosphorus is preferably surface-treated for preventing hydrolysis or the like. Examples of a surface treatment method include (i) a method of coating with an inorganic compound such as magnesium hydroxide, aluminum hydroxide, zinc hydroxide, titanium hydroxide, bismuth oxide, bismuth hydroxide, bismuth nitrate, or a mixture thereof, (ii) a method of coating with a mixture of an inorganic compound, such as magnesium hydroxide, aluminum hydroxide, zinc hydroxide, or titanium hydroxide, and a thermosetting resin, such as a phenol resin, (iii) a doubly coating method of coating with a film of an inorganic compound such as magnesium hydroxide, aluminum hydroxide, zinc hydroxide, or titanium hydroxide, and coating the film with a thermosetting resin such as a phenol resin, and the like.

Examples of the organic phosphorus compound include general-purpose organic phosphorus compounds such as phosphate compounds, phosphonic acid compounds, phosphinic acid compounds, phosphine oxide compounds, phospholan compounds, organic nitrogen-containing phosphorus compounds, and the like; cyclic organic phosphorus compounds such as 9,10-dihydro-9-oxa-10-phosphaphenanthrene=10-oxide, 10-(2,5-dihydroxyphenyl)-10H-9-oxa-10-phosphaphenanthrene=10-oxide, 10-(2,7-dihydroxynaphthyl)-10H-9-oxa-10-phosphaphenanthrene=10-oxide, and the like; and derivatives produced by reaction of the phosphorus compounds with a compound such as an epoxy resin, a phenol resin, or the like.

The mixing amount is appropriately selected according to the type of the phosphorus-based flame retardant, the other components of the curable resin composition, and the desired degree of flame retardancy. For example, when red phosphorus is used as the non-halogen flame retardant, the flame retardant is preferably mixed in a rage of 0.1 to 2.0 parts by mass in 100 parts by mass of the curable resin composition containing all of the epoxy resin, the curing agent, the non-halogen flame retardant, filler, and the other additives. Similarly, when the organic phosphorus compound is used, it is preferably mixed in a range of 0.1 to 10.0 parts by mass, particularly preferably in a range of 0.5 to 6.0 parts by mass.

When the phosphorus-based flame retardant is used, the phosphorus-based flame retardant may be combined with hydrotalcite, magnesium hydroxide, a boron compound, zirconium oxide, a black dye, calcium carbonate, zeolite, zinc molybdate, activated carbon, or the like.

Examples of the nitrogen-based flame retardant include triazine compounds, cyanuric acid compounds, isocyanuric acid compounds, phenothiazine, and the like, and the triazine compounds, the cyanuric acid compounds, and the isocyanuric acid compounds are preferred.

Examples of the triazine compounds include melamine, acetoguanamine, benzoguanamine, melon, melam, succinoguanamine, ethylenedimelamine, melamine polyphosphate, triguanamine, (i) aminotriazine sulfate compounds such as guanylmelamine sulfate, melem sulfate, melam sulfate, and the like; (ii) co-condensates of phenols, such as phenol, cresol, xylenol, butylphenol, and nonylphenol, with melamines, such as melamine, benzoguanamine, acetoguanamine, and formguanamine, and formaldehyde; (iii) mixtures of the co-condensates (ii) and phenol resins such as phenolformaldehyde condensates; and (iv) the co-condensates (ii) and the mixtures (iii) further modified with tung oil, isomerized linseed oil, or the like.

Examples of the cyanuric acid compounds include cyanuric acid, melamine cyanurate, and the like.

The amount of the nitrogen-based flame retardant mixed is appropriately selected according to the type of the nitrogen-based flame retardant, the other components of the curable resin composition, and the desired degree of flame retardancy. For example, the nitrogen-based flame retardant is preferably mixed in the range of 0.05 to 10 parts by mass, particularly preferably in the range of 0.1 to 5 parts by mass, in 100 parts by mass of the curable resin composition containing all of the epoxy resin, the curing agent, the non-halogen flame retardant, filler, and the other additives.

In addition, the nitrogen-based flame retardant may be used in combination with a metal hydroxide, a molybdenum compound, or the like.

The silicone-based flame retardant is not particularly limited and can be used as long as it is an organic compound containing a silicon atom. Examples thereof include silicone oil, silicone rubber, silicone resins, and the like.

The amount of the silicone-based flame retardant mixed is appropriately selected according to the type of the silicone-based flame retardant, the other components of the curable resin composition, and the desired degree of flame retardancy. For example, the silicone-based flame retardant is preferably mixed in the range of 0.05 to 20 parts by mass

in 100 parts by mass of the curable resin composition containing all of the epoxy resin, the curing agent, the non-halogen flame retardant, filler, and the other additives. In addition, the silicone-based flame retardant may be used in combination with a molybdenum compound, alumina, or the like.

Examples of the inorganic flame retardant include metal hydroxides, metal oxides, metal carbonate compounds, metal powders, boron compounds, low-melting-point glass, and the like.

Examples of the metal hydroxides include aluminum hydroxide, magnesium hydroxide, dolomite, hydrotalcite, calcium hydroxide, barium hydroxide, zirconium hydroxide, and the like.

Examples of the metal oxides include zinc molybdate, molybdenum trioxide, zinc stannate, tin oxide, aluminum oxide, iron oxide, titanium oxide, manganese oxide, zirconium oxide, zinc oxide, molybdenum oxide, cobalt oxide, bismuth oxide, chromium oxide, nickel oxide, copper oxide, tungsten oxide, and the like.

Examples of the metal carbonate compounds include zinc carbonate, magnesium carbonate, calcium carbonate, barium carbonate, basic magnesium carbonate, aluminum carbonate, iron carbonate, cobalt carbonate, titanium carbonate, and the like.

Examples of the metal powders include powders of aluminum, iron, titanium, manganese, zinc, molybdenum, cobalt, bismuth, chromium, nickel, copper, tungsten, tin, and the like.

Examples of the boron compounds include zinc borate, zinc metaborate, barium metaborate, boric acid, borax, and the like.

Examples of the low-melting-point glass include Seaplea (Bokusui Brown Co., Ltd.), hydrated glass $SiO_2$-MgO-$H_2O$, and PbO-$B_2O_3$-based, ZnO-$P_2O_5$-MgO-based, $P_2O_5$-$B_2O_3$-PbO-MgO-based, P-Sn-O-F-based, PbO-$V_2O_5$-$TeO_2$-based, $Al_2O_3$-$H_2O$-based, and lead borosilicate-based glass compounds.

The amount of the inorganic flame retardant mixed is appropriately selected according to the type of the inorganic flame retardant, the other components of the curable resin composition, and the desired degree of flame retardancy. For example, the inorganic flame retardant is preferably mixed in a range of 0.5 to 50 parts by mass, particularly preferably in a range of 5 to 30 parts by mass, in 100 parts by mass of the curable resin composition containing all of the epoxy resin, the curing agent, the non-halogen flame retardant, filler, and the other additives.

Examples of the organic metal salt-based flame retardant include ferrocene, acetylacetonate metal complexes, organic metal carbonyl compounds, organic cobalt salt compounds, organic sulfonic acid metal salts, compounds each having an ionic bond or coordinate bond between a metal atom and an aromatic compound or heterocyclic compound, and the like.

The amount of the organic metal salt-based flame retardant mixed is appropriately selected according to the type of the organic metal salt-based flame retardant, the other components of the curable resin composition, and the desired degree of flame retardancy. For example, the organic metal salt-based flame retardant is preferably mixed in the range of 0.005 to 10 parts by mass in 100 parts by mass of the curable resin composition containing all of the epoxy resin, the curing agent, the non-halogen flame retardant, filler, and the other additives.

If required, an inorganic filler can be mixed in the curable resin composition of the present invention. Examples of the inorganic filler include fused silica, crystalline silica, alumina, silicon nitride, aluminum hydroxide, and the like. When the amount of the inorganic filler mixed is particularly increased, the fused silica is preferably used. Although either crushed or spherical fused silica can be used, the spherical fused silica is preferably mainly used for increasing the amount of the fused silica mixed and suppressing an increase in melt viscosity of a molding material. In order to further increase the amount of the spherical silica mixed, the grain size distribution of the spherical silica is preferably properly adjusted. The filling rate is preferably in the range of 0.5 to 100 parts by mass in 100 parts by mass of the curable resin composition. In addition, in use for an application such as a conductive paste, conductive filler such as a silver powder, a copper powder, or the like can be used.

If required, various compounding agents such as a silane coupling agent, a mold release agent, a pigment, an emulsifier, etc. can be added to the curable resin composition of the present invention.

The curable resin composition of the present invention can be produced by uniformly mixing the above-described components. The curable resin composition containing the epoxy resin and the curing agent of the present invention, and further containing a curing accelerator according to demand can be easily formed into a cured product by the same as a general known method. Examples of the cured product include molded cured products such as a laminate, a cast product, an adhesive layer, a coating film, a film, and the like.

Applications using the curable resin composition of the present invention include printed circuit board materials, resin casting materials, adhesives, interlayer insulating materials for build-up substrates, adhesive films for build-up, and the like. Among these various applications, in applications to an insulating material for a printed circuit board and electronic circuit board and an adhesive film for build-up, the curable resin composition can be used as an insulating material for a so-called electronic component-built-in substrate in which a passive component such as a capacitor and an active component such as an IC chip are embedded in the substrate. In particular, the curable resin composition is preferably used as a printed circuit board material and an adhesive film for build-up from the viewpoint of characteristics such as high heat resistance and flame retardancy.

A method for producing a printed circuit board using the curable resin composition of the present invention is, for example, a method of impregnating a reinforcement substrate with a resin composition varnish, which is prepared by further mixing the organic solvent (C) with a varnish-like curable resin composition containing the organic solvent (C), and then heat and pressure bonding a copper foil laminated on the substrate. As the reinforcement substrate, paper, a glass cloth, a glass nonwoven fabric, aramid paper, an aramid cloth, a glass mat, a glass roving cloth, and the like can be used. In further detail, the method includes first heating the varnish-like curable resin composition at a heating temperature according to the type of solvent used, preferably 50 to 170°C, to form a prepreg as a cured product. The mass ratio between the resin composition and the reinforcement substrate used is not particularly limited but is preferably adjusted so that the resin content in the prepreg is 20 to 60% by mass. Next, the prepregs formed as described above are stacked by a usual method, and a copper foil is appropriately laminated thereon and heat-pressure bonded at 170 to 250°C for 10 minutes to 3 hours under a pressure of 1 to 10 MPa, thereby producing the intended printed circuit board.

When the curable resin composition of the present invention is used as a resist ink, as a usable method, for example, a resist ink composition is prepared by adding a cationic polymerization catalyst as a catalyst for the curable resin composition and further a pigment, talc, and filler, applied on a printed board by a screen printing method, and then cured to form a resist ink cured product.

When the curable resin composition of the present invention is used as conductive paste, examples of a usable method include a method of preparing a composition for an anisotropic conductive film by dispersing conductive fine particles in the curable resin composition, and a method of preparing a circuit-connecting paste resin composition or an anisotropic conductive adhesive which is liquid at room temperature.

As a method for producing an interlayer insulating material for a build-up board from the curable resin composition of the present invention, for example, the curable resin composition appropriately containing rubber and filler is applied to a circuit board having a circuit formed thereon by a spray coating method, a curtain coating method, or the like, and then cured. Then, if required, predetermined through holes are formed, and then a surface is treated with a coarsening agent, washed with hot water to form projections and depressions, and then plated with a metal such as copper. As the plating method, electroless plating and electrolytic plating are preferred, and an oxidizer, an alkali, and an organic solvent can be used as the coarsening agent. Such an operation is successively repeated according to demand to alternately build up a resin insulating layer and a conductor layer of a predetermined circuit pattern, thereby producing a build-up board. However, the through holes are formed after the outermost resin insulating layer is formed. Also, a build-up substrate can be formed by pressure-bonding a copper foil with a resin, which is formed by semi-curing the resin composition on the copper foil, under heating at 170 to 250°C on the circuit board having a circuit formed thereon, without the steps of forming a coarsened surface and of plating.

A method for producing an adhesive film for build up from the curable resin composition of the present invention is, for example, a method of applying the curable resin composition of the present invention on a support film to form a resin composition layer, thereby forming an adhesive film for a multilayer printed circuit board.

When the curable resin composition of the present invention is used for an adhesive film for build up, it is important for the adhesive film to soften at a lamination temperature condition (usually 70°C to 140°C) in a vacuum lamination method and to exhibit fluidity (resin flow) which permits resin filling in via holes or through holes present in the circuit board at the same time as lamination on the circuit board. Therefore, the above-described components are preferably mixed so as to exhibit these characteristics.

The through holes in the multilayer printed circuit board generally have a diameter of 0.1 to 0.5 mm and a depth of 0.1 to 1.2 mm, and can be filled with the resin within this range. When both surfaces of the circuit board are laminated, the through holes are preferably about 1/2 filled.

Specifically, the method for producing the adhesive film includes preparing the varnish-like curable resin composition of the present invention, applying the varnish-like composition on a surface of a support film (y), and further drying the organic solvent by heating or hot air spraying to form a curable resin composition layer (x).

The thickness of the layer (x) formed is not less than the thickness of the conductor layer. Since the thickness of the conductor layer provided in the circuit board is generally in the range of 5 to 70 μm, the thickness of the resin composition layer is preferably 10 to 100 μm.

The layer (x) according to the present invention may be protected by a protecting film described below. Protecting by the protecting film can prevent adhesion of dust to the surface of the resin composition layer and scratches thereon.

Examples of the support film and the protecting film include films of polyolefins such as polyethylene, polypropylene, polyvinyl chloride, and the like, polyesters such as polyethylene terephthalate (may be abbreviated as "PET" hereinafter), polyethylene naphthalate, and the like, polycarbonate, polyimide, release paper, and metal foils such as a copper foil, an aluminum foil, and the like. The support film and the protecting film may be subjected to MAD treatment, corona treatment, or release treatment.

The thickness of the support film is not particularly limited, but is generally 10 to 150 μm and preferably in a range of 25 to 50 μm. The thickness of the protecting film is preferably 1 to 40 μm.

The support film (y) is separated after being laminated on the circuit board or after the insulating film is formed

by heat curing. When the support film (y) is separated after the adhesive film is heat-cured, adhesion of dust in the curing step can be prevented. When the support film is separated after curing, generally, the support film is previously subjected to release treatment.

Next, in the method for producing the multilayer printed circuit board using the adhesive film formed as described above, for example, when the layer (x) is protected by the protecting film, the protecting film is separated, and then the layer (x) is laminated on one or both surfaces of the circuit board by, for example, a vacuum lamination method so that the layer is in direct contact with the circuit board. The lamination method may be a butch mode or a continuous mode using a roll. In addition, if required, the adhesive film and the circuit board may be heated (preheated) before the lamination.

The lamination is preferably performed under the lamination conditions including a pressure-bonding temperature (lamination temperature) of 70°C to 140°C and a pressure-bonding pressure of 1 to 11 $kgf/cm^2$ ($9.8 \times 10^4$ to $107.9 \times 10^4$ $N/m^2$), and under reduced air pressure of 20 mmHg (26.7 hPa) or less.

A method for producing a cured product of the present invention may be based on a general method for curing a curable resin composition. For example, a heating temperature condition may be appropriately selected according to the type of the curing agent combined and use thereof, but the composition prepared by the above-described method may be heated in the temperature range of about 20°C to about 250°C.

Therefore, when the cured product is produced by using the heat-curable phenol resin composition, heat resistance and low thermal expansibility can be exhibited, thereby permitting application to most-advanced printed circuit board materials. In addition, the phenol resin composition can be easily efficiently produced by the production method of the present disclosure, and molecular design can be realized according to the level of the above-described intended performance.

EXAMPLES

Next, the present invention is described in further detail with reference to examples and comparative examples, and "parts" and "%" below are on a mass basis unless otherwise specified. In addition, a softening point, GPC, and $^{13}C$-NMR, and MS were measured under conditions described below.

1) Softening point measuring method: according to JIS K7234
2) GPC: The measurement conditions are as follows.
Measurement apparatus: "HLC-8220 GPC" manufactured by Tosoh Corporation
Column: Guard Column "HXL-L" manufactured by Tosoh Corporation
+ "TSK-GEL G2000HXL" manufactured by Tosoh Corporation
+ "TSK-GEL G2000HXL" manufactured by Tosoh Corporation
+ "TSK-GEL G3000HXL" manufactured by Tosoh Corporation
+ "TSK-GEL G4000HXL" manufactured by Tosoh Corporation
Detector: RI (differential refractometer)
Data processing: "GPC-8020 model II version 4.10" manufactured by Tosoh Corporation
Measurement conditions:

| | |
|---|---|
| Column temperature | 40°C |
| Developing solvent | tetrahydrofuran |
| Flow rate | 1.0ml/min |

Standard: using monodisperse polystyrene having a known molecular weight according to a measurement manual of the "GPC-8020 model II version 4.10".
(Polystyrene used)
"A-500" manufactured by Tosoh Corporation
"A-1000" manufactured by Tosoh Corporation
"A-2500" manufactured by Tosoh Corporation
"A-5000" manufactured by Tosoh Corporation
"F-1" manufactured by Tosoh Corporation
"F-2" manufactured by Tosoh Corporation
"F-4" manufactured by Tosoh Corporation
"F-10" manufactured by Tosoh Corporation
"F-20" manufactured by Tosoh Corporation
"F-40" manufactured by Tosoh Corporation
"F-80" manufactured by Tosoh Corporation
"F-128" manufactured by Tosoh Corporation

Sample: prepared by filtering, with a microfilter, a tetrahydrofuran solution of 1.0% by mass in terms of resin solid content (50 μl).
3) $^{13}$C-NMR: The measurement conditions are as follows.

Apparatus: AL-400 manufactured by JEOL, Ltd.
Measurement mode: SGNNE (NOE-suppressed 1H complete decoupling method)
Solvent: dimethylsulfoxide
Pulse angle: 45°C pulse
Sample concentration: 30 wt%
Number of acquisitions: 10000

4) <Method for calculating molar ratio [naphthoquinone skeleton (q)/carbon atom to which phenolic hydroxyl group (p) is bonded]>

In measurement of the novel phenol resin of the present invention under the above-described $^{13}$C-NMR measurement conditions, a relation between the integrated value (α) of a peak of a carbon atom, to which a phenolic hydroxyl group (p) is bonded and which is detected between 145 ppm and 160 ppm, and the integrated value (β) of a peak of a carbon atom, to which a oxygen of the naphthoquinone skeleton (q) is bonded and which is detected between 170 ppm and 190 ppm, satisfies expression (1) and expression (2) below. Here, (X) represents the number of moles of the phenolic hydroxyl group (p), and (Y) represents the number of moles of the naphthoquinone skeleton (q).

$$X = \alpha \qquad \text{Expression (1)}$$

$$Y = \beta/2 \qquad \text{Expression (2)}$$

Therefore, the molar ratio can be calculated as a value of (Y/X) in expression (3) below from the expression (1) and expression (2) .

$$Y/X = \beta/2\alpha \qquad \text{Expression (3)}$$

5) MS: mass spectroscope "MALDI-MASS AXIMA-TOF2" manufactured by Shimadzu Biotech Co., Ltd.
6) Method for calculating average number of nuclei
The average number of nuclei can be calculated according to a calculation expression below using the number-average molecular weight (Mn) of the phenol resin measured under the above-described GPC measurement conditions. In the expression below, "Y" represents a mass number of the naphthol skeleton (n), "Z" represents a mass number of the naphthoquinone skeleton (q), "p" represents a ratio (molar ratio) of the naphthol skeleton (n) present to the naphthoquinone skeleton (q) present, and "q" represents a ratio (molar ratio) of the naphthoquinone skeleton (q) present to the naphthol skeleton (n) present.

$$\text{Average number of nuclei} = (Mn - x)/(x + 12) + 1$$

$$x = p/100 \times Y + q/100 \times Z$$

More specifically, "p" and "q" are each a value derived by a calculation method for a molar ratio [naphthoquinone skeleton (q)/carbon atom to which phenolic hydroxyl group (p) is bonded] according to $^{13}$C-NMR measurement described below.
7) FT-IR measurement condition

Apparatus: FT/IR-4200 type A manufactured by JASCO Corporation
Measurement method: KBr tablet method
Measurement mode: absorbance (Abs)
Resolution: 4 $cm^{-1}$

Number of acquisitions: 32
Abscissa: Wavenumber ($cm^{-1}$)
Ordinate: Abs

8) <Method for calculating quinone absorbance ratio>

In FT-IR measurement of the novel phenol resin of the present invention under the above-described FT-IR measurement conditions, a quinone absorbance ratio ($\gamma/\omega$) is calculated from an absorption value ($\gamma$) of a peak due to a quinone skeleton, which is detected between 1560 $cm^{-1}$ and 1600 $cm^{-1}$, and an absorption value ($\omega$) of a peak due to an aromatic skeleton detected between 1630 $cm^{-1}$ and 1670 $cm^{-1}$.

The peak absorption values ($\gamma$) and ($\omega$) are calculated from a height from a base line between the minimum absorption value (a) at 1500 $cm^{-1}$ to 1560 $cm^{-1}$ and the minimum absorption value (b) at 1660 $cm^{-1}$ to 1800 $cm^{-1}$.

EXAMPLE 1

In a flask provided with a thermometer, a dropping funnel, a cooling tube, a fractionating column, and a stirrer, 505 parts by mass (3.50 moles) of $\alpha$-naphthol, 158 parts by mass of water, and 5 parts by mass of oxalic acid were charged, and the resultant mixture was stirred under heating from room temperature to 100°C over 45 minutes. Then, 177 parts by mass (2.45 moles) of a 42 mass% aqueous formalin solution was added dropwise over 1 hour. After the completion of addition, the mixture was further stirred at 100°C for 1 hour and then heated to 180°C over 3 hours. After the completion of reaction, water remaining in the reaction system was removed by heating under reduced pressure to produce 498 parts by mass of phenol resin (A-1). The resultant phenol resin (A-1) had a softening point of 133°C (B & R method) and a hydroxyl equivalent of 154 g/eq. Then, 150 parts of the resultant (A-1) was ground and treated for 9 hours in an air atmosphere of 80°C to produce 150 parts of quinone skeleton-containing phenol resin (A-2). The resultant quinone skeleton-containing phenol resin (A-2) had a softening point of 140°C (B & R method) and a hydroxyl equivalent of 153 g/eq. Fig. 1 shows a GPC chart of the quinone skeleton-containing phenol resin (A-2). The average number of nuclei determined from the GPC chart was 4.3. The molar ratio [naphthoquinone skeleton (q)/carbon atom to which phenolic hydroxyl group (p) is bonded] was 2.3/97.7, and the quinone absorbance ratio was 0.16.

EXAMPLE 2

According to the same method as in Example 1 except that the raw material components were changed to 505 parts by mass (3.50 moles) of $\alpha$-naphthol, 21 parts by mass (number of moles of cresol skeleton: 0.18 moles) of cresol novolac resin having a softening point of 75°C (B & R method), and 186 parts by mass (2.57 moles) of a 42 mass% aqueous formalin solution, 521 parts by mass of phenol resin (A-3) was produced. The resultant phenol resin (A-3) had a softening point of 129°C (B & R method) and a hydroxyl equivalent of 152 g/eq. Then, 150 parts of the resultant (A-3) was ground and treated for 18 hours in an air atmosphere of 80°C to produce 151 parts by mass of quinone skeleton-containing phenol resin (A-4). The resultant quinone skeleton-containing phenol resin (A-4) had a softening point of 147°C (B & R method) and a hydroxyl equivalent of 150 g/eq. Fig. 2 shows a GPC chart of the quinone skeleton-containing phenol resin (A-4), Fig. 3 shows a $^{13}C$-NMR chart, Fig. 4 shows a MS spectrum, and Fig. 5 shows a FT-IR chart. The average number of nuclei determined from the GPC chart was 4.6. In the $^{13}C$-NMR chart, a peak indicating the production of a quinone skeleton was detected near 184 ppm. The molar ratio [naphthoquinone skeleton (q)/carbon atom to which phenolic hydroxyl group (p) is bonded] was 5.9/94.1, and the quinone absorbance ratio was 0.36.

EXAMPLE 3

According to the same method as in Example 1 except that the treatment time in the air atmosphere of 80°C was changed to 18 hours, 151 parts by mass of quinone skeleton-containing phenol resin (A-5) was produced. The resultant quinone skeleton-containing phenol resin (A-5) had a softening point of 149°C (B & R method) and a hydroxyl equivalent of 152 g/eq. Fig. 6 shows a GPC chart of the quinone skeleton-containing phenol resin (A-5). The average number of nuclei determined from the GPC chart was 4.3. The molar ratio [naphthoquinone skeleton (q)/carbon atom to which phenolic hydroxyl group (p) is bonded] was 5.0/95.0, and the quinone absorbance ratio was 0.40.

EXAMPLE 4

According to the same method as in Example 1 except that the treatment time in the air atmosphere of 80°C was changed to 27 hours, 151 parts of quinone skeleton-containing phenol resin (A-6) was produced. The resultant quinone skeleton-containing phenol resin (A-6) had a softening point of 158°C (B & R method) and a hydroxyl equivalent

of 152 g/eq. Fig. 7 shows a GPC chart of the quinone skeleton-containing phenol resin (A-6). The average number of nuclei determined from the GPC chart was 4.1. The molar ratio [naphthoquinone skeleton (q)/carbon atom to which phenolic hydroxyl group (p) is bonded] was 7.8/92.2, and the quinone absorbance ratio was 0.69.

EXAMPLE 5

According to the same method as in Example 1 except that the treatment time in the air atmosphere of 80°C was changed to 36 hours, 151 parts of quinone skeleton-containing phenol resin (A-7) was produced. The resultant quinone skeleton-containing phenol resin (A-7) had a softening point of 167°C (B & R method) and a hydroxyl equivalent of 151 g/eq. Fig. 8 shows a GPC chart of the quinone skeleton-containing phenol resin (A-7). The average number of nuclei determined from the GPC chart was 4.0. The molar ratio [naphthoquinone skeleton (q)/carbon atom to which phenolic hydroxyl group (p) is bonded] was 10.9/89.1, and the quinone absorbance ratio was 0.85.

EXAMPLES 6 to 10 and COMPARATIVE EXAMPLES 1 and 2

According to the compositions shown in Table 1 below, "N-770" (phenol novolac epoxy resin, epoxy equivalent: 183 g/eq) manufactured by DIC Corporation used as an epoxy resin, the phenol resins (A-1) to (A-7), and 2-ethyl-4-methylimidazole (2E4MZ) used as a curing accelerator were mixed, and methyl ethyl ketone was mixed so that the nonvolatile content (N. V.) in each of the final compositions was 58% by mass.

Next, a laminated plate was formed on an experimental basis by curing under conditions described below and evaluated with respect to heat resistance by methods described below. The results are shown in Table 1.

<Conditions for forming laminated plate>

Substrate: Glass Cloth "#2116" (210 × 280 mm) manufactured by Nitto Boseki Co., Ltd.
Number of plies: 6 Prepregnating condition: 160°C
Curing conditions: 1.5 hours at 200°C and 40 kg/$cm^2$
Thickness after molding: 0.8 mm

<Heat resistance (glass transition temperature)>

A temperature with the maximum change in elastic modulus (maximum rate of change in tan $\delta$) was evaluated as the glass transition temperature using a viscoelasticity measuring apparatus (DMA: solid viscoelasticity measuring apparatus RSAII manufactured by Rheometric Scientific Inc., rectangular tension method; frequency 1 Hz, heating rate 3 °C/min).

<Coefficient of thermal expansion (coefficient of linear expansion)>

The laminated plate was cut into a size of 5 mm × 5 mm × 0.8 mm and used as a test piece for compression-mode thermal mechanical analysis using a thermal mechanical analyzer (TMA: SS-6100 manufactured by Seiko Instruments Inc.).

Measurement conditions

Measurement load: 88.8 mN

Temperature-rising rate: 2 times at 3 °C/min

Measurement temperature range: -50°C to 300°C

Measurement under the above-described conditions was performed two times for the same sample, and, in the second measurement, the average coefficient of expansion in the temperature range of 240°C to 280°C was evaluated as the coefficient of linear expansion.

[Table 1]

| | | Example 6 | Example 7 | Example 8 | Example 9 | Example 10 | Comparative Example 1 | Comparative Example 2 |
|---|---|---|---|---|---|---|---|---|
| Phenol resin | A-1 | | | | | | 45.7 | |
| | A-2 | 45.5 | | | | | | |
| | A-3 | | | | | | | 45.4 |
| | A-4 | | 45 | | | | | |
| | A-5 | | | 45.4 | | | | |
| | A-6 | | | | 45.4 | | | |
| | A-7 | | | | | 45.2 | | |
| Epoxy resin | N-770 | 54.5 | 55 | 54.6 | 54.6 | 54.8 | 54.3 | 54.6 |
| 2E4MZ | | 0.05 | 0.05 | 0.05 | 0.05 | 0.05 | 0.05 | 0.05 |
| Heat resistance (°C) | | 242 | 254 | 247 | 251 | 253 | 232 | 231 |
| Coefficient of linear expansion (ppm) | | 212 | 197 | 207 | 201 | 199 | 235 | 230 |

In Table 1, abbreviations are as follows.

"A-1": phenol resin (A-1) produced in Example 1
"A-2": phenol resin (A-2) containing a quinone skeleton produced in Example 1
"A-3": phenol resin (A-3) produced in Example 2
"A-4": phenol resin (A-4) containing a quinone skeleton produced in Example 2
"A-5": phenol resin (A-5) containing a quinone skeleton produced in Example 3
"A-6": phenol resin (A-6) containing a quinone skeleton produced in Example 4
"A-7": phenol resin (A-7) containing a quinone skeleton produced in Example 5
"N-770": phenol novolac epoxy resin ("N-770" manufactured by DIC Corporation, epoxy equivalent 183 g/eq)
"2E4MZ": 2-ethyl-4-methylimidazole

Reference Signs List

a ... minimum absorption value at 1500 $cm^{-1}$ to 1560 $cm^{-1}$
b ... minimum absorption value at 1660 $cm^{-1}$ to 1800 $cm^{-1}$
$\gamma$ ... peak absorption value due to a quinone skeleton calculated from height from a base line between a and b
$\omega$ ... peak absorption value due to an aromatic skeleton calculated from height from a base line between a and b

## Claims

1. A novel phenol resin having a resin structure in which a naphthol skeleton (n) and a naphthoquinone skeleton (q) are bonded through a methylene bond, wherein a polycondensate (a) of a naphthol compound and formaldehyde is oxidized to form the naphthoquinone skeleton (q) in a resin structure of the polycondensate, and wherein the naphthoquinone skeleton (q) is represented by structural formula q1 or q2 below:

[Chem. 1]

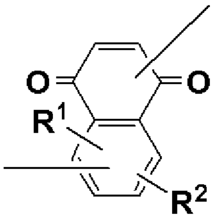

q1

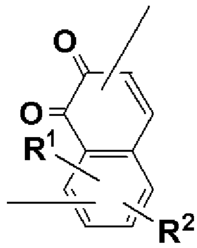

q2

(wherein $R^1$ and $R^2$ are each independently a hydrogen atom, a methyl group, an ethyl group, or a methoxy group, and two lines in the structural formula q1 or q2 each indicate a bond to another structural site and may be positioned on the same ring or different rings of the two rings constituting the structure).

**2.** The novel phenol resin according to Claim 1, wherein the polycondensate (a) is produced by polycondensation of the formaldehyde with the naphthol compound used in combination with another phenol compound or a phenol novolac resin or a cresol novolac resin.

**3.** The novel phenol resin according to Claim 1 or 2, wherein the ratio of the naphthoquinone skeleton (q) present to a phenolic hydroxyl group (p) present in the novel phenol resin is 0.1/99.9 to 20/80 in terms of molar ratio [naphthoquinone skeleton (q)/carbon atom to which phenolic hydroxyl group (p) is bonded] determined by $^{13}C$-NMR measurement.

**4.** The novel phenol resin according to any one of Claims 1 to 3, wherein the average total number of nuclei (a condensed ring in the skeletons is regarded as 1 nucleus) of the naphthol skeleton (n) and the naphthoquinone skeleton (q) is in a range of 3 to 10.

**5.** A curable resin composition comprising, as essential components, a curing agent (A) for an epoxy resin and an epoxy resin (B), wherein the curing agent (A) for an epoxy resin includes the novel phenol resin according to any one of Claims 1 to 4.

**6.** A cured product produced by a curing reaction of the curable resin composition according to Claim 5.

**7.** A printed circuit board produced by impregnation of a reinforcement substrate with a resin composition varnish and then lamination, the resin composition varnish being prepared by mixing the curable resin composition according to Claim 5 with an organic solvent (C).

## Patentansprüche

**1.** Neuartiges Phenolharz mit einer Harzstruktur, in welcher ein Naphthol-Grundgerüst (n) und ein Naphthochinon-Grundgerüst (q) durch eine Methylenbindung verbunden sind, wobei ein Polykondensat (a) einer Naphtholverbindung und Formaldehyd unter Bildung des Naphthochinon-Grundgerüsts (q) in einer Harzstruktur des Polykondensats oxidiert ist, und wobei das Naphthochinon-Grundgerüst (q) dargestellt wird durch die folgende Strukturformel q1 oder q2:

[Chem. 1]

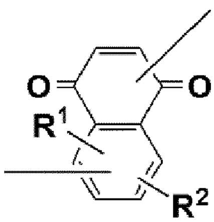

q1

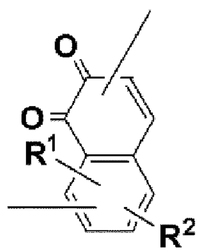

q2

(worin $R^1$ und $R^2$ jeweils unabhängig ein Wasserstoffatom, eine Methylgruppe, eine Ethylgruppe oder eine Methoxygruppe sind und zwei Linien in der Strukturformel q1 oder q2 jeweils eine Bindung zu einer anderen Strukturstelle anzeigen und an demselben Ring oder verschiedenen Ringen der beiden die Struktur aufbauenden Ringe positioniert sein können).

2. Neuartiges Phenolharz gemäß Anspruch 1, wobei das Polykondensat (a) hergestellt wird durch Polykondensation des Formaldehyds mit der Naphtholverbindung, die in Kombination mit einer weiteren Phenolverbindung oder einem Phenol-Novolak-Harz oder einem Cresol-Novolak-Harz verwendet wird.

3. Neuartiges Phenolharz gemäß Anspruch 1 oder 2, wobei das Verhältnis des vorliegenden Naphthochinon-Grundgerüsts (q) zu einer phenolischen Hydroxylgruppe (p), die in dem neuartigen Phenolharz vorliegt, 0,1/99,9 bis 20/80 bezüglich des molaren Verhältnisses [Naphthochinon-Grundgerüst (q)/Kohlenstoffatom, an welches die phenolische Hydroxylgruppe (p) gebunden ist] beträgt, bestimmt durch $^{13}C$-NMR-Messung.

4. Neuartiges Phenolharz gemäß einem der Ansprüche 1 bis 3, wobei die durchschnittliche Gesamtanzahl an Kernen (ein kondensierter Ring in den Grundgerüsten wird als 1 Kern angesehen) des Naphthol-Grundgerüsts (n) und des Naphthochinon-Grundgerüsts (q) in einem Bereich von 3 bis 10 liegt.

5. Härtbare Harzzusammensetzung, umfassend als wesentliche Komponenten ein Härtungsmittel (A) für ein Epoxyharz und ein Epoxyharz (B), wobei das Härtungsmittel (A) für ein Epoxyharz das neuartige Phenolharz gemäß einem der Ansprüche 1 bis 4 umfasst.

6. Gehärtetes Produkt, hergestellt durch Härtungsreaktion der härtbaren Harzzusammensetzung gemäß Anspruch 5.

7. Leiterplatte, hergestellt durch Imprägnieren eines Verstärkungssubstrats mit einem Harzzusammensetzungslack und anschließender Laminierung, wobei der Harzzusammensetzungslack durch Vermischen der härtbaren Harzzusammensetzung gemäß Anspruch 5 mit einem organischen Lösungsmittel (C) hergestellt ist.

## Revendications

1. Nouvelle résine phénolique ayant une structure de résine dans laquelle un squelette de naphtol (n) et un squelette de naphtoquinone (q) sont liés par une liaison méthylène, dans laquelle un polycondensat (a) d'un composé de naphtol et de formaldéhyde est oxydé pour former le squelette de naphtoquinone (q) dans une structure de résine du polycondensat, et dans laquelle le squelette de naphtoquinone (q) est représenté par la formule développée q1 ou q2 ci-dessous :

[Chim. 1]

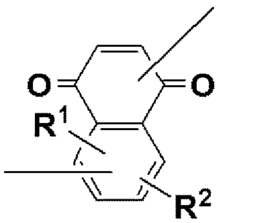
q1

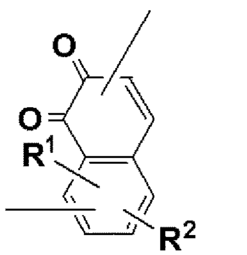
q2

(dans laquelle $R^1$ et $R^2$ sont chacun indépendamment un atome d'hydrogène, un groupe méthyle, un groupe éthyle ou un groupe méthoxy, et deux lignes dans la formule développée q1 ou q2 indiquent chacune une liaison à un autre site structurel et peuvent être positionnées sur le même cycle ou des cycles différents des deux cycles constituant la structure).

2. Nouvelle résine phénolique selon la revendication 1, dans laquelle le polycondensat (a) est produit par polycondensation du formaldéhyde avec le composé de naphtol utilisé en combinaison avec un autre composé de phénol ou une résine novolaque phénolique ou une résine novolaque crésolique.

3. Nouvelle résine phénolique selon la revendication 1 ou 2, dans laquelle le rapport du squelette de naphtoquinone

(q) présent à un groupe hydroxyle phénolique (p) présent dans la nouvelle résine phénolique est de 0,1/99,9 à 20/80 en termes de rapport molaire [squelette de naphtoquinone (q)/atome de carbone auquel est lié un groupe hydroxyle phénolique (p)] déterminé par mesure par $^{13}C$-RMN.

**4.** Nouvelle résine phénolique selon l'une quelconque des revendications 1 à 3, dans laquelle le nombre total moyen de noyaux (un cycle condensé dans les squelettes est considéré comme 1 noyau) du squelette de naphtol (n) et du squelette de naphtoquinone (q) est dans une plage allant de 3 à 10.

**5.** Composition de résine durcissable comprenant, en tant que composants essentiels, un agent de durcissement (A) pour une résine époxy et une résine époxy (B), dans laquelle l'agent de durcissement (A) pour une résine époxy inclut la nouvelle résine phénolique selon l'une quelconque des revendications 1 à 4.

**6.** Produit durci produit par une réaction de durcissement de la composition de résine durcissable selon la revendication 5.

**7.** Carte de circuits imprimés produite par imprégnation d'un substrat de renforcement avec un vernis de composition de résine et puis stratification, le vernis de composition de résine étant préparé en mélangeant la composition de résine durcissable selon la revendication 5 avec un solvant organique (C).

FIG. 1

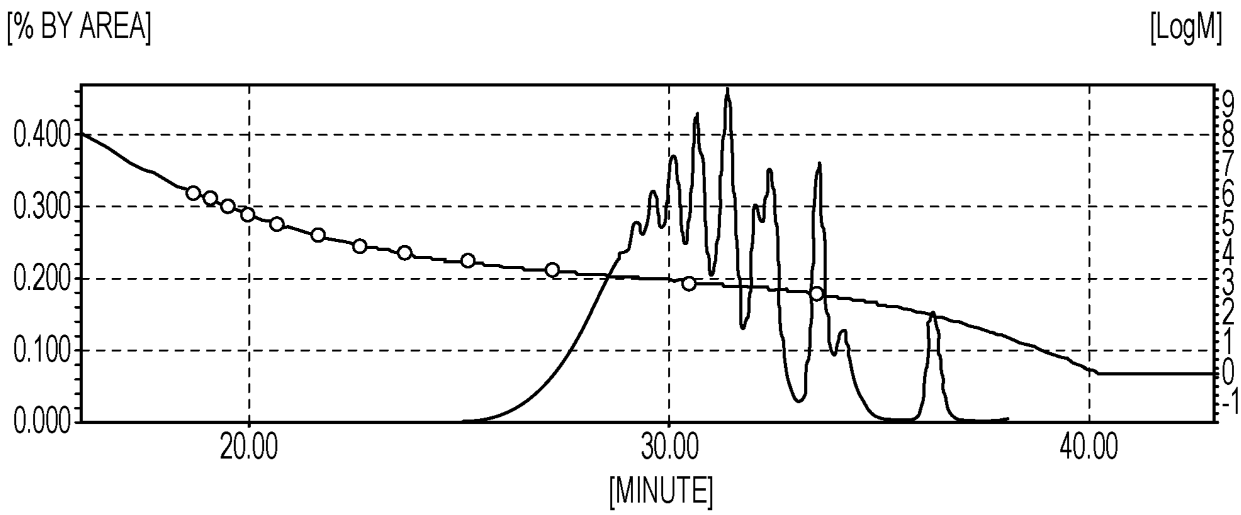
[% BY AREA]
[LogM]
0.400
0.300
0.200
0.100
0.000
9
8
7
6
5
4
3
2
1
0
-1
20.00
30.00
40.00
[MINUTE]

FIG. 2

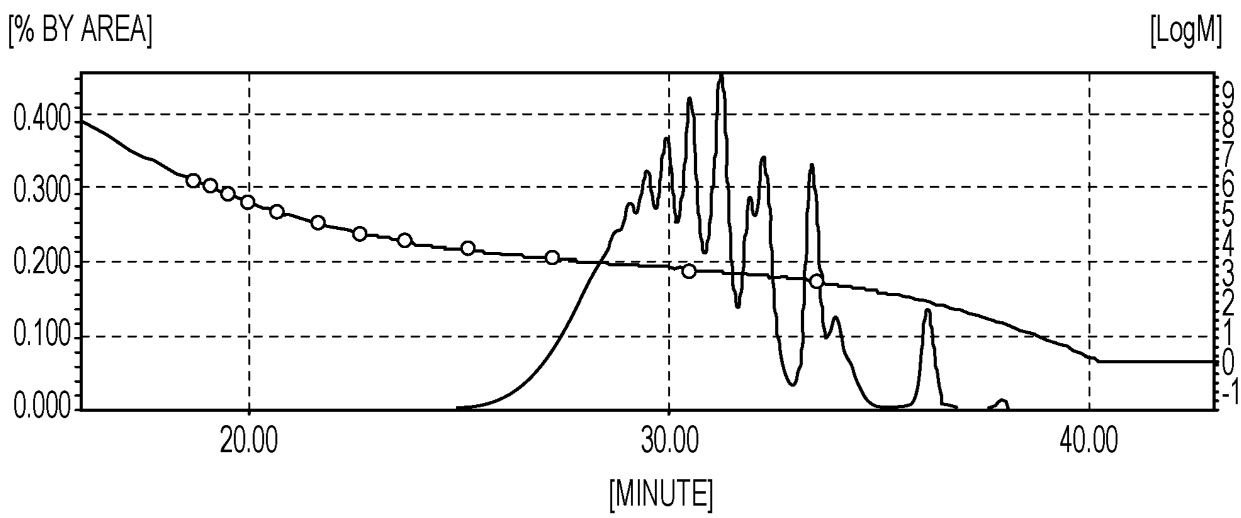
[% BY AREA]
[LogM]
0.400
0.300
0.200
0.100
0.000
9
8
7
6
5
4
3
2
1
0
-1
20.00
30.00
40.00
[MINUTE]

FIG. 3

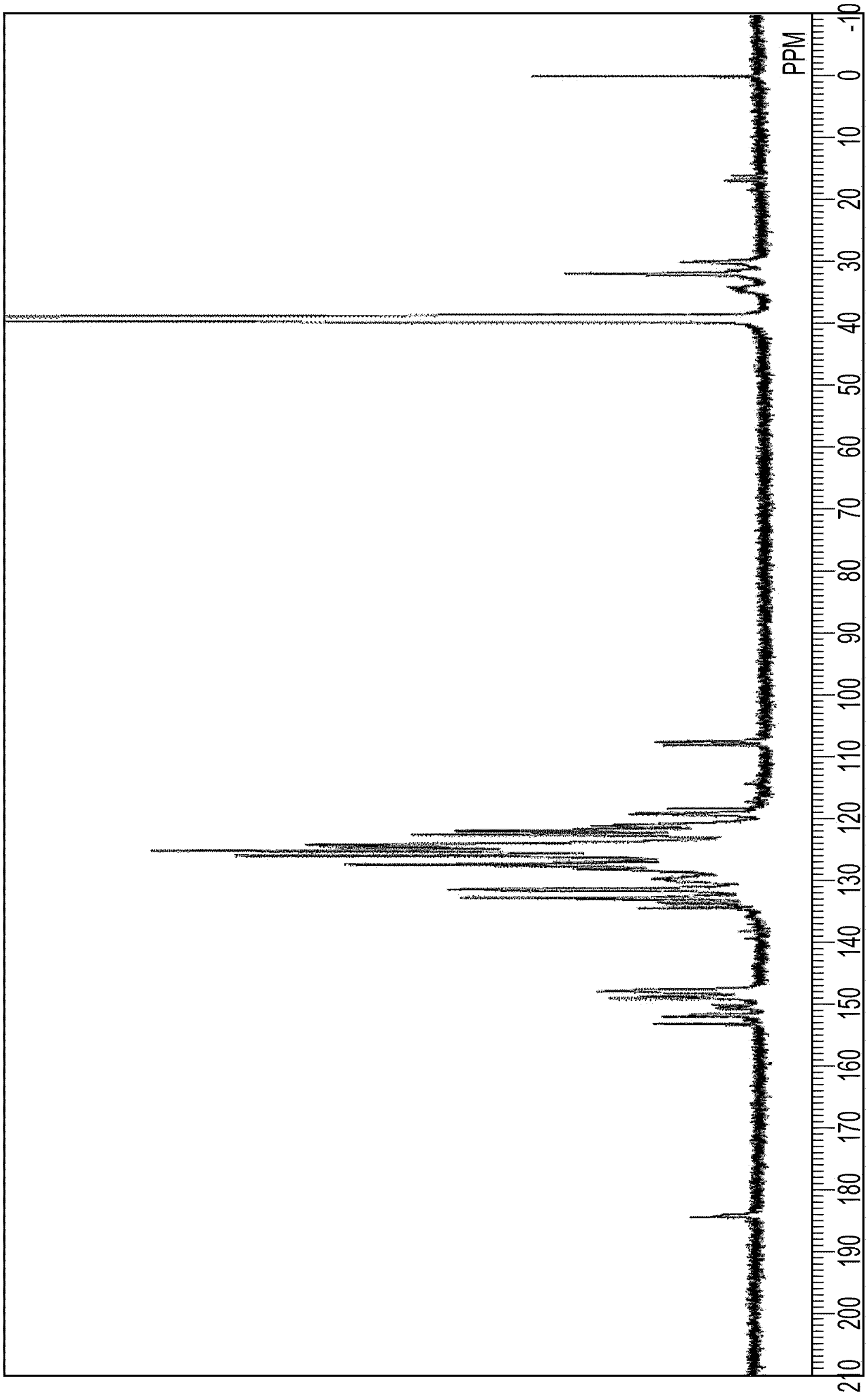
PPM
-10
0
10
20
30
40
50
60
70
80
90
100
110
120
130
140
150
160
170
180
190
200
210

FIG. 4

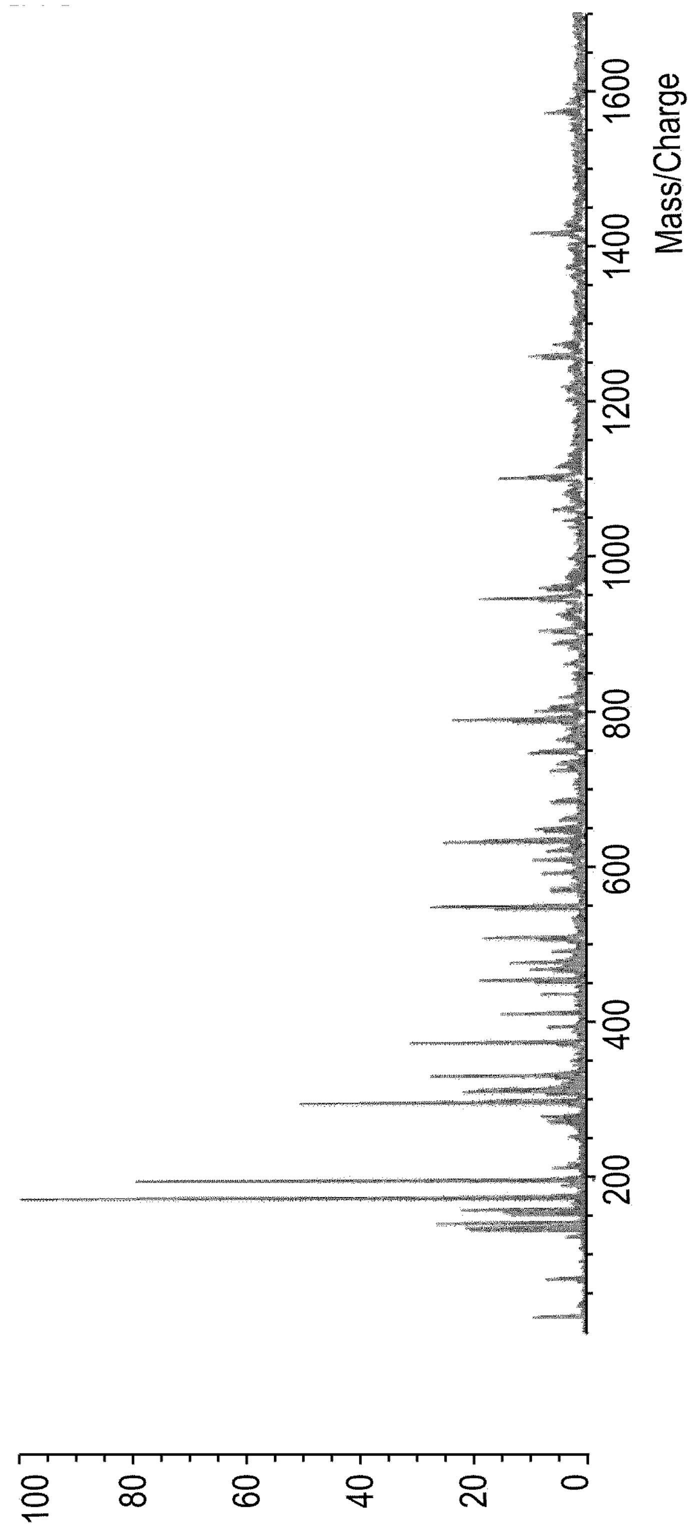
Mass/Charge
200
400
600
800
1000
1200
1400
1600
0
20
40
60
80
100

FIG. 5

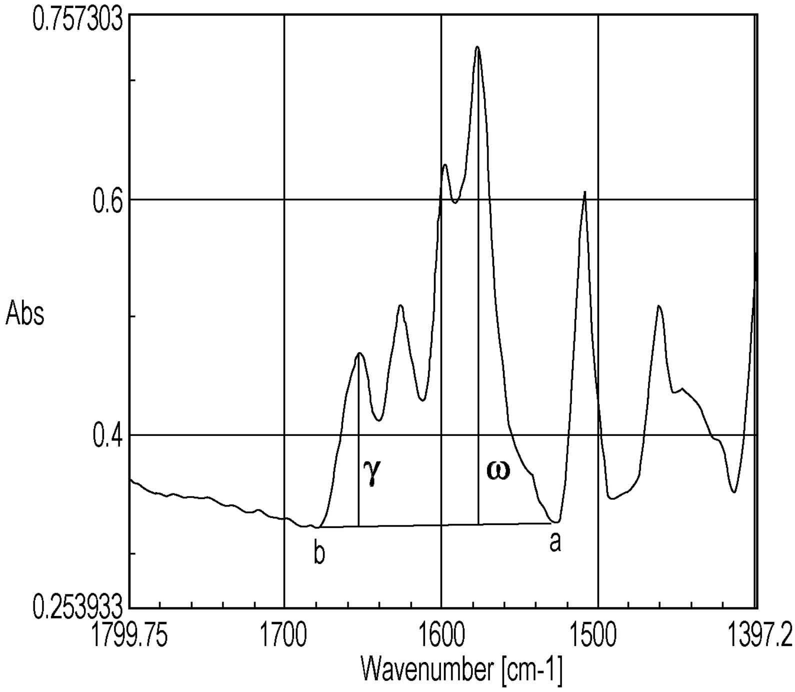


FIG. 6

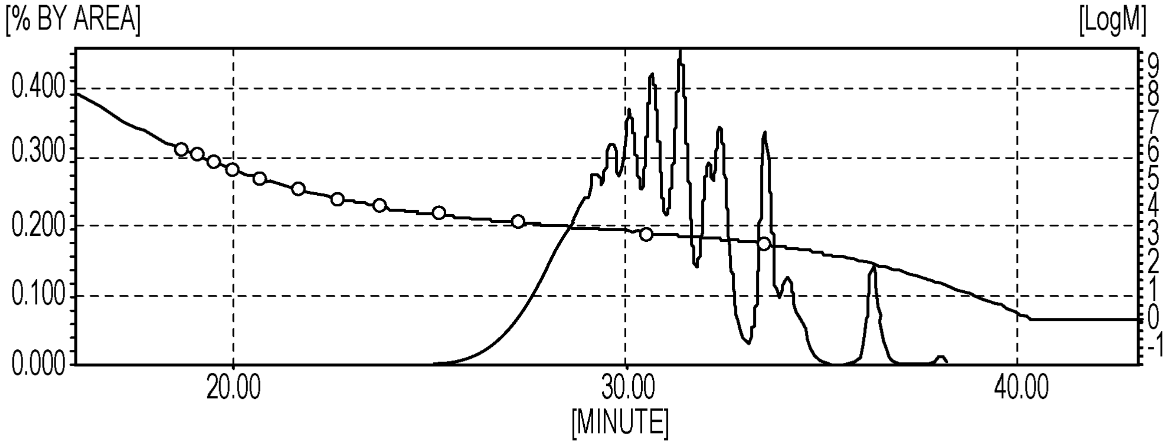


FIG. 7

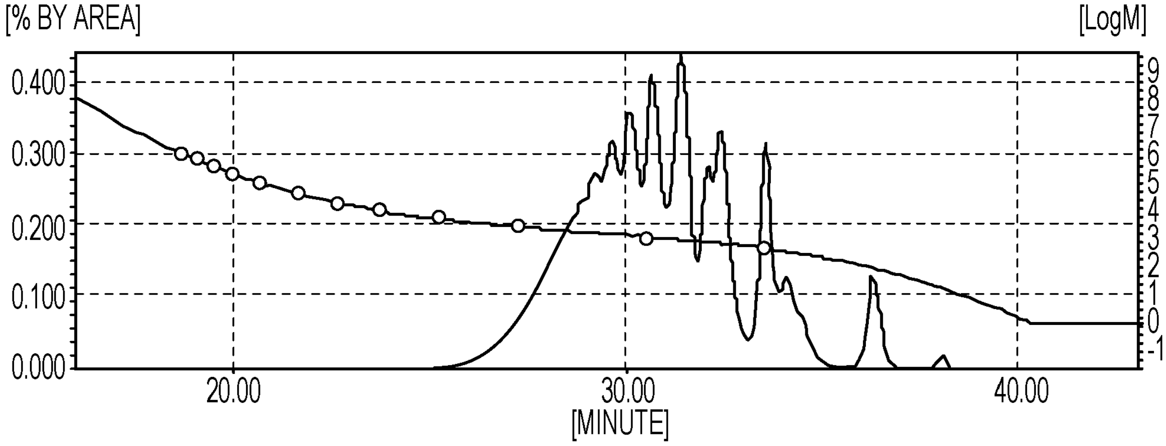

FIG. 8

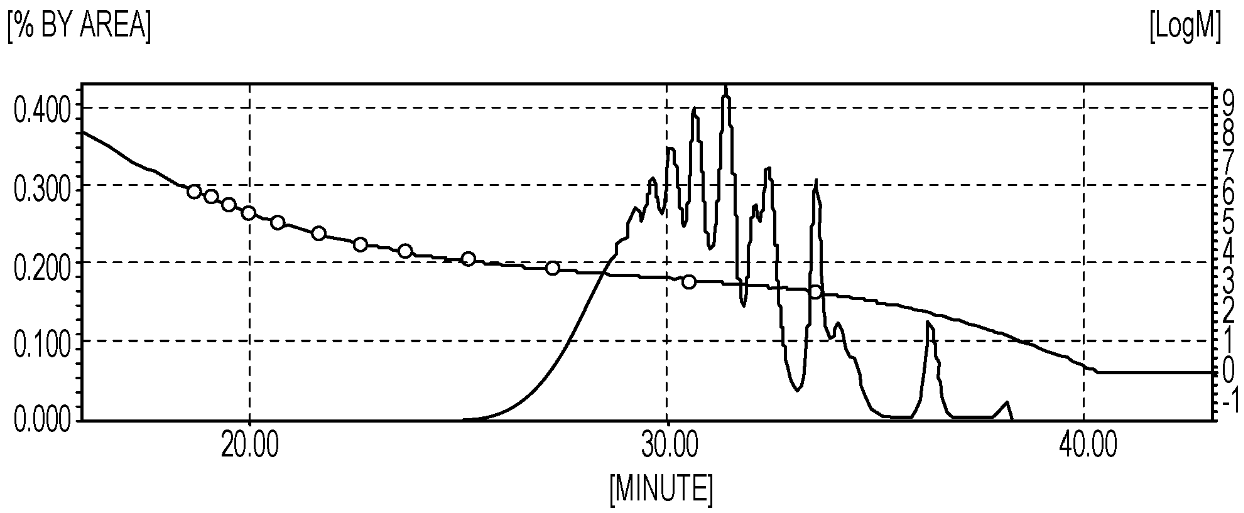
[% BY AREA]
[LogM]
0.400
0.300
0.200
0.100
0.000
9
8
7
6
5
4
3
2
1
0
-1
20.00
30.00
40.00
[MINUTE]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2007031527 A
- JP 2009155638 A
- JP 2004277624 A
- JP 2004197020 A
- EP 0512519 A
- EP 0136110 A